# EUROPEAN PATENT APPLICATION

(11) **EP 4 383 324 A1**
(43) Date of publication of application: **12.06.2024**
(21) Application number: 22306825.5
(22) Date of filing: 08.12.2022
(51) Int. Cl.: H01L 21/78, H01L 23/00, H01L 25/065, H01L 25/00, H01L 25/16

(54) **SEMICONDUCTOR STRUCTURE AND MANUFACTURING METHOD THEREOF**

(71) Applicant: Murata Manufacturing Co., Ltd., Nagaokakyo-shi, Kyoto 617-8555 (JP); Commissariat à l'énergie atomique et aux énergies alternatives, 75015 Paris (FR)
(72) Inventor: SCANNELL, Mark, 38054 GRENOBLE CEDEX 09 (FR); VOIRON, Frédéric, 38530 BARRAUX (FR)
(74) Representative: Cabinet Beau de Loménie

(57) **Abstract**

The present invention relates to a semiconductor structure (100) comprising:
- a wafer (110) comprising a first bonding face (111),
- an array of chiplets (A_1) assembled in one piece and having a second bonding face (A_1_2).

Moreover, the area of said second bonding face is smaller than the area of said first bonding face, and said second bonding face being connected by hybrid bonding to said first bonding face.

## Description

### Field of the invention

The present invention relates to the general field of semiconductor products design, conception and manufacturing. It relates more particularly to a semiconductor structure, and to a method of manufacturing said semiconductor structure.

### Technical background

Semiconductor devices are used in a variety of electronic applications, such as personal computers, cell phones, digital cameras, and other electronic equipment. They are typically fabricated by sequentially depositing insulating or dielectric layers, conductive layers, and semiconductive layers of material over a semiconductor substrate, and patterning the various material layers using lithography to form circuit components and elements thereon.

3D (three dimensional) integration of such semiconductor devices has been achieved in the past few years by the introduction of fine processes and improvements in package density. For example, the PICS technology developed by Murata Integrated Passive Solutions allows high density capacitive components to be integrated into a silicon substrate. According to this technology, tens or even hundreds of passive components can be efficiently integrated into a silicon die.

As part of these integration processes, bonding technologies between semiconductor devices play a key role. In this respect, the hybrid bonding technology (a member of the direct bonding technology family) developed in recent years is now widely used. Hybrid bonding is an innovative technology being developed for next-generation packaged devices, which provides a bonding solution based on small copper-to-copper connections (i.e., via closely spaced copper pads), so as to completely avoid the use of bumps.

More specifically, hybrid bonding aims at bonding a first semiconductor device to a second semiconductor device so as to simultaneously achieve electrical communication and mechanical bonding between the devices. The meaning of the term "hybrid" stems from the fact that two-different materials on said first semiconductor device are directly bonded to the 'same two-different' materials of said second semiconductor device, i.e. a first metal pad (respectively a surrounding insulator material of said first metal pad) located on said first semiconductor device is bonded to a corresponding second metal pad (respectively a surrounding insulator material of said second metal pad) located on said second semiconductor device.

From a practical point of view, hybrid bonding is conventionally implemented using two different assembly approaches: either die-to-wafer (DtW) connection or wafer-to-wafer (WtW) connection (the term "wafer" classically refers to a thin round slice of semiconductor material, such as crystalline silicon, used for the fabrication of integrated circuits).

As regards the WtW approach, the hybrid bonding occurs at the wafer level (before dicing occurs) between two wafers of the same size (i.e. two wafers whose bonding faces have identical areas). The DtW approach, on the other hand, is carried out at a finer level corresponding to that of the die.

The WtW approach is generally considered easier and more cost effective than the DtW approach. Indeed, as hybrid bonding requires very specific surface preparations, it is more efficient to implement it with two whole wafers rather than a multitude of separate dies. Furthermore, handling of whole wafers is easier than handling of dies (i.e., less of manipulation and alignment constraints). Finally, bonding throughput is much higher when the hybrid bonding is done collectively rather than one-by-one, which would be the case with the DtW approach (i.e., the WtW approach allows the assembly of several chips in parallel, whereas the DtW approach is limited by the need for serial assembly).

For these reasons, and despite the ability of the DtW approach to further enable heterogeneous integration, WtW hybrid bonding has been in production predominantly for several years. However, the latter also suffers from certain defects. In particular, the need to use wafers of the same size to achieve effective bonding is a major implementation constraint.

In addition, wafer stress across the wafer can lead to wafer bowing which complicates the process when performing hybrid bonding, including but not limited to, making the correct alignment of the copper pads difficult to achieve.

### Summary of the invention

The purpose of the present invention is to overcome all or part of the limitations of the prior art solutions, particularly those outlined here above, by providing a solution that allows a hybrid bonded semiconductor structure to be produced much more efficiently than prior art solutions.

By "more efficiently", it is referred to the fact that the misalignment of the copper pads is minimised, while guaranteeing, during the production phase, a minimisation of stress related bowing as well as a very easy handling of the various elements necessary for the manufacture of the structure, but also a high throughput of bonding.

To this end, and according to a first aspect, the invention relates to a semiconductor structure comprising:
- a wafer comprising a first bonding face,
- an array of chiplets assembled in one piece and having a second bonding face.
Moreover, the area of said second bonding face is smaller than the area of said first bonding face, and said second bonding face is connected by hybrid bonding to said first bonding face.

By "chiplet", it is classically referred to a small integrated circuit (IC) die which is configured to perform a particular function. An array of chiplets can therefore be seen as a multi-die array, with the chiplets arranged in a grid and held together.

Therefore, the semiconductor structure according to the invention differs from the state of the art in that it adopts an intermediate approach between the DtW approach and the WtW approach. In this case, it is a "Multi-Die to Wafer" approach, each array of chiplets forming a manipulable and movable block/monolithic assembly (before it is connected by hybrid bonding to the wafer), with the chiplets that belong to said array held together.

These arrangements are particularly advantageous as they avoid the pitfalls of the DtW approach in relation to the need for multiple operations to manipulate and move the chiplets it incorporates.

Furthermore, as the hybrid bonding is carried out at a lower level (in terms of surface area) than the WtW approach, it also avoids the pitfalls of the WtW approach (i.e., the misalignment of the copper pads is minimised, while guaranteeing, during the production phase, a minimisation of stress related bowing), while at the same time ensuring excellent results in terms of the throughput of bonding.

According to particular embodiments, the semiconductor structure may furthermore include one or more of the following features, taken alone or in any technically feasible combination.

According to particular embodiments, said structure comprises a plurality of arrays of chiplets (i.e. separate arrays), each array being assembled in one piece and having a second bonding face, the respective areas of each of said second bonding faces being smaller than the first bonding face area, and each array being connected by hybrid bonding to said first bonding face.

According to particular embodiments, at least a part of said plurality of arrays of chiplets forms a contiguous tiling.

According to particular embodiments, the arrays of at least a part of said plurality of arrays of chiplets are all spaced apart.

This embodiment is particularly advantageous as it allows leaving accessible a portion of the first bonding face, and allows forming electrical connections on this first bonding face. This allows avoiding having to implement structures such as through silicon vias through the chiplets or the wafer to form electrical connections (especially when a front-to-front assembly is manufactured).

According to particular embodiments, wherein the chiplets of at least one array are electrically independent of each other.

According to particular embodiments, the electrically independent chiplets are separated by an insulating region (for example an insulating trench delimiting each chiplets).

According to particular embodiments, at least one chiplet of at least one array comprises a capacitor having capacitor electrodes, at least one capacitor electrode being electrically accessible on the second bonding face of said at least one chiplet.

This embodiment is advantageous when implemented with the above described embodiment indicating that a plurality of arrays of chiplets are all spaced apart: as there is at least one capacitor electrode accessible on the second bonding face (and possibly the two electrodes are accessible), the chiplets are assembled from their front-side, which renders difficult accessing the capacitor electrodes from the unassembled face. Because there are portions of the wafer that are accessible, electrical connections (i.e. connection pads) can be formed between the arrays.

According to particular embodiments, the electrodes of the capacitor extend inside pores of an insulating porous structure.

The insulating porous structure can be obtained by anodizing a layer of a metal such as aluminum. The pores are straight pores, extending in a perpendicular manner from a face initially exposed of the metal to be anodized. In fact, the pores and the capacitor can be similar to the ones described in document WO 2015/063420 A1.

According to particular embodiments, the number of chiplets in an array is comprised between 1 and 1000, more particularly between 1 and 100, and still more particularly between 1 and 10.

According to particular embodiments, the second bonding face of the array of chiplets has an area comprised between 1 mm² and 10 cm².

According to particular embodiments, at least one of said arrays of chiplets is hybridly bonded to a die of the wafer or to an array of dies of the wafer.

According to particular embodiments, the part of the first bonding face bounded by said die or said array of dies comprises an electric contact pad.

According to a second aspect, the invention also relates to a method of manufacturing a semiconductor structure according to the invention.

In particular embodiments, the training method may furthermore include one or more of the following features, taken alone or in any technically feasible combination.

According to particular embodiments, the method further comprises a step of dicing at least one portion of the semiconductor structure, said portion being formed of at least one array of chiplets and the part of the wafer hybridly bonded to said at least one array of chiplets.

### Brief description of the drawings

Further features and advantages of the present invention will become apparent from the following description of certain embodiments thereof, given by way of illustration only, not limitation, with reference to the accompanying drawings in which:
- FIG. 1 schematically illustrates a particular embodiment of a semiconductor structure according to the invention, said semiconductor structure being shown in a state prior to the implementation of a hybrid bonding between a wafer and elements corresponding to arrays of chiplets,
- FIG. 2 is a top view of the semiconductor structure of FIG. 1,
- FIG. 3 is a top view of a semiconductor structure according to another embodiment of the invention,
- FIG. 4 is a flowchart illustrating a particular embodiment of a method of manufacturing a semiconductor structure according to the invention.

### Detailed description of example embodiments

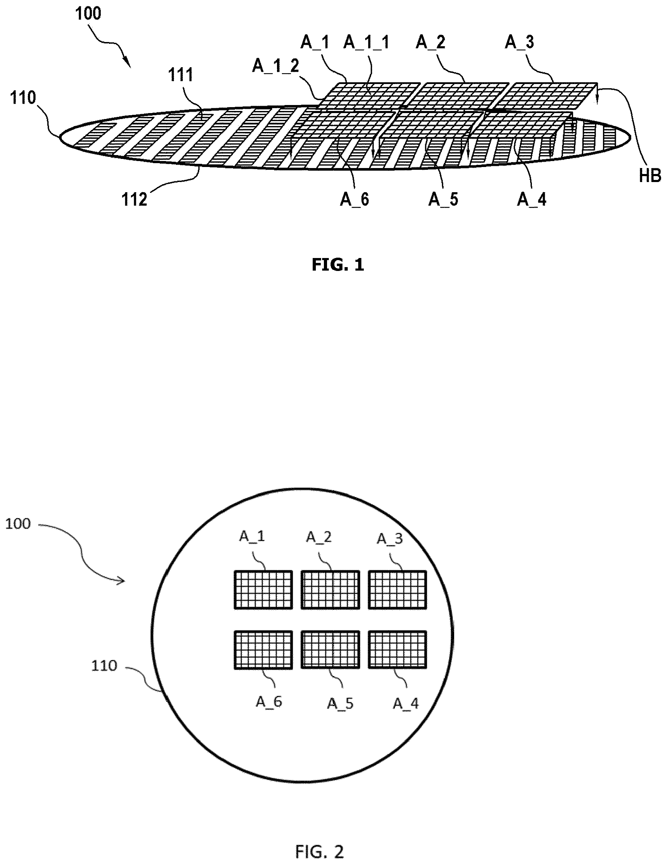

FIG. 1 schematically illustrates a particular embodiment of a semiconductor structure 100 according to the invention. More particularly, the semiconductor structure 100 is shown in a state prior to the implementation of a hybrid bonding between a wafer and elements corresponding to arrays of chiplets which will now be described in detail.

The semiconductor structure 100 is, for example, intended for the manufacture of electronic components for HPC (High Performance Computing) application. Of course, this is only one such example of application, and any other industrial application for which a semiconductor structure is conventionally intended may be considered within the meaning of the present invention.

As illustrated in FIG. 1, the semiconductor structure 100 comprises a wafer 110 conventionally having a substantially circular shape (when viewed in the main plane in which it extends; by substantially, what is meant is that the circular edge can include notches and flat cuts).

Said wafer 110 constitutes a support comprising, in particular, a set of dies, the number of dies being conventionally between a few tens and a few thousands, this aspect being related to the size of the wafer 110 in terms of diameter as well as to the size of the dies in terms of surface area.

By way of example, the wafer 110 may have a diameter of approximately 200 mm or 300 mm. The dies, for their part, may have a surface area of the order of one square millimetre (or less) up to about tens or hundreds of square millimetres. Of course, nothing excludes the possibility of considering, according to other examples not detailed here, higher or lower values in terms of wafer diameter and/or die surface.

The wafer 100 may also form, as a whole, an active or passive component. Alternatively, the dies embedded in the wafer 110 may be assembled into a plurality of arrays, each of which arrays forming an active or passive component.

Generally speaking, said wafer 110 may be of any type known to the skilled person, no limitation being attached to this aspect in the context of the present invention.

As illustrated in FIG. 1, the wafer 110 has two opposing faces, respectively a top face 111 and a bottom face 112 (hidden on the figure). The upper face 111 is the face on which arrays of chiplets are connected by hybrid bonding as detailed later, so that it is hereinafter referred to as "first bonding face 111" (said hybrid bonding is symbolized by vertical arrows bearing the reference sign "HB" in FIG. 1).

As mentioned above, the semiconductor structure 100 also comprises a plurality of arrays of chiplets A_1, ..., A_N, N being an integer strictly greater than 1 in the present embodiment.

More particularly, in the embodiment described herein with reference to FIG. 1, the number N is equal to 6. Considering six arrays of chiplets is, however, only one alternative implementation of the invention, and nothing excludes considering a number greater or less than six.

Furthermore, although a plurality of arrays will be considered for the remainder of the description, the invention is of course still applicable in the case where a single array is contemplated (N = 1).

By "chiplet", it is classically referred to a small integrated circuit (IC) die which is configured to perform a particular function (an array of chiplets can therefore be seen as a multi-die array). This function can be of any nature, provided that it contributes to the industrial application for which the semiconductor structure 100 is intended once manufactured (e.g., imaging device).

By "array", it is classically referred to a structure of generally rectangular or square shape (when observed in the main plane in which it extends).

By way of example, the number of chiplets of an array A_i is comprised between 1 and 1000, more particularly between 1 and 100, even more particularly between 1 and 10. However, it is possible to contemplate other values for the number of chiplets in an array, according to other examples not detailed here.

Each array of chiplets A_i (i is an integer between 1 and N) is assembled in one piece. In other words, each array A_i forms a manipulable and movable block/monolithic assemby (before it is connected by hybrid bonding to wafer 110), with the chiplets that belong to said array A_i held together. Put another way, an array of chiplets is manipulable and movable without the need for multiple operations to manipulate and move the chiplets it incorporates.

Furthermore, similar to what has been described for wafer 110, each array of chiplets A_i has two opposing faces, respectively a top face A_i_1 and a bottom face A_i_2 (for the sake of simplicity, only the references "A_1_1" and "A_1_2" are shown in FIG. 1). The lower face A_i_2 is the face connected by hybrid bonding to the first bonding face 111 of the wafer 110, so that it is referred to hereafter as the "second bonding face A_i_2".

As a non-limiting example, the second bonding face A_i_2 of an array A_i may have an area comprised between 1 mm² and 10 cm².

It should be noted that the surface treatments that can be applied to the first bonding face 111 and the second bonding faces A_i_2 of each of the arrays A_1, ..., A_N, so that they are configured to allow connections to be made by hybrid bonding, are well known to the skilled person, so that they are not repeated here.

In accordance with the invention, the area of the second bonding face A_i_2 of each of the arrays A_1, ..., A_N is smaller than the area of the first bonding face 111. It follows implicitly from these provisions that, in the context of the implementation of a semiconductor structure 100 according to the invention, the sum of the areas of the second bonding faces A_i_2 is smaller than the area of the first bonding face 111 (otherwise, one or more chiplets would not be connected to the wafer 110 as a result of the hybrid bonding).

The hybrid bonding of an array of chiplets A_i to the wafer 110 may be performed in different ways in terms of the surfaces connected to each other. Thus, for example, an array of chiplets A_i may be hybridly bonded (via its second bonding face A_i_2) to a die of wafer 110. According to another example, an array of chiplets A_i may be hybridly bonded (via its second bonding face A_i_2) to an array of dies of the wafer 110.

Furthermore, in a more particular embodiment, in order to provide an electrical connection to the stack formed by an array of chiplets A_i with the corresponding portion of the wafer 110 to which said array A_i is hybridly bonded, the part of the first bonding face 111 which is bounded by said die or said array of dies of the wafer 110 may comprise an electrical contact pad.

It should be noted, however, that the invention also covers other embodiments capable of providing an electrical connection to such a stack, for example by exploiting other areas of the first bonding face 111 left free after the implementation of the hybrid bonding, but also by using the bottom face 112 of the wafer 110 and/or the top face A_i_1 of an array of chiplets A_i.

As regards the electrical connection between the chiplets of an array A_i, any solution known to the skilled person can be envisaged.

Thus, in a particular embodiment, the chiplets of at least one array A_i (possibly of each of the arrays A_1, ..., A_N) are electrically independent of each other. In other words, according to such a particular embodiment, there is no electrical link between adjacent chiplets of an array, each chiplet therefore having its own function. It is understood, however, that even if chiplets in an array are electrically independent of each other, they are still electrically connected to the same substrate on which they lie in a known manner.

An example of implementing such electrical independence between chiplets may be to separate said chiplets by an insulating region. This insulating region may, for example, result from making trenches between chiplets, said trenches being filled with a suitable insulator (e.g. dielectric material).

However, the use of trenches filled with insulating material is only one variant of implementation, and nothing excludes the possibility of other variants (e.g. the use of a diode-type insulating structure). Generally speaking, any method known to the skilled person for achieving electrical independence between chiplets can be contemplated.

As mentioned above, each chiplet corresponds to a small integrated circuit (IC) die which is configured to perform a particular function. Thus, in a particular embodiment, at least one chiplet of at least one array A_i comprises a capacitor having capacitor electrodes, at least one capacitor electrode being electrically accessible on the second bonding face A_i_2 of said at least one chiplet (i.e., on the portion of the second bonding face A_i_2 of said at least one array A_i which belongs to said at least one chiplet).

According to a more specific example, the electrodes of the capacitor may extend inside pores of an insulating porous structure.

In general, any type of capacitor structure can be considered for a chiplet, and in particular a capacitor structure based entirely or partly on the PICS technology developed by Murata Integrated Passive Solutions. For more details on the PICS technology, it is possible to refer to document WO 2015063420.

In the embodiment of FIG. 1, arrays A_1, ..., A_6 are identical to each other. More particularly, the arrays A_1, ..., A_6 are all identical in rectangular shape, and all comprise the same number of chiplets. Furthermore, the areas of the second bonding faces A_1_2, ..., A_6_2 belonging to the arrays A_1, ..., A_6 are also all identical. The configuration of FIG. 1 is further characterized in that the arrays A_1, ..., A_6 are all spaced apart, this aspect being more visible in FIG. 2 which corresponds to a top view of the semiconductor structure 100.

Such a configuration is not, however, limiting to the invention, which still covers all other technically possible variants, in particular in terms of combination of the four aforementioned criteria: shape (rectangular or square), number of chiplets, areas of the second bonding faces A_i_2, spacing between arrays of chiplets.

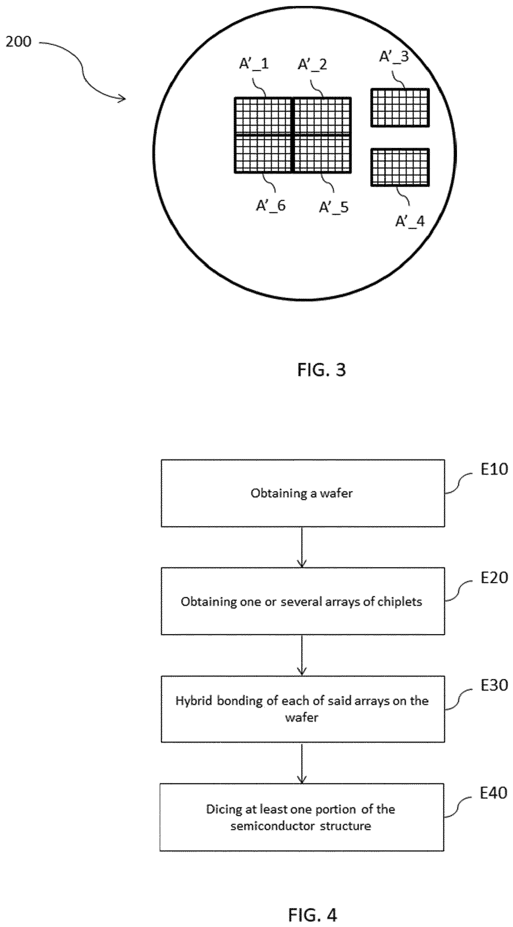

In particular, nothing excludes the possibility that at least some of the arrays A_i (possibly all the arrays A_1, ..., A_N) are arranged in such a way as to form a continuous tiling. Such an example of continuous tiling is shown in FIG. 3, where a semiconductor structure 200 according to the invention comprises four arrays A'_1, A'_2, A'_5, A'_6 forming a continuous tiling, whereas two other arrays A'_3, A'_4 are spaced apart from each other and from the other arrays A'_1, A'_2, A'_5, A'_6.

The invention has so far been described in relation to aspects of the semiconductor structure 100 only. However, the invention still covers other aspects, including in particular a method of manufacturing said semiconductor structure 100.

Such a manufacturing method may, for example, comprise, as illustrated in FIG. 4, steps of:
- obtaining E10 a wafer 110,
- obtaining E20 one or several arrays of chiplets A_1,..., A_N, said arrays A_1,..., A_N being configured so that the area of each of the second bonding faces A_1_2,..., A_N_2 is smaller than that of the first bonding face 111 of the wafer 110,
- hybrid bonding E30 of each of said arrays of chiplets A_1, ..., A_N on the wafer 110.

Optionally, and as illustrated in FIG. 4, the method may further comprise a step E40 of dicing at least one portion of the semiconductor structure 100, said portion being formed of at least one array of chiplets A_i and the part of the wafer 110 hybridly bonded to said at least one array of chiplets A_i. For this purpose, any manner known to the skilled person for performing such a step E40 may be used.

## Claims

1. A semiconductor structure (100) comprising:
- a wafer (110) comprising a first bonding face (111),
- an array of chiplets (A_1) assembled in one piece and having a second bonding face (A_1_2),
the area of said second bonding face being smaller than the area of said first bonding face, and said second bonding face being connected by hybrid bonding to said first bonding face.

2. The semiconductor structure (100) according to claim 1, wherein said structure comprises a plurality of arrays of chiplets (A_1, A_2, A_3, A_4, A_5, A_6), each array being assembled in one piece and having a second bonding face, the respective areas of each of said second bonding faces being smaller than the first bonding face area, and each array being connected by hybrid bonding to said first bonding face.

3. The semiconductor structure (100) according to claim 2, wherein at least a part of said plurality of arrays of chiplets form a contiguous tiling.

4. The semiconductor structure (100) according to any one of claims 2 to 3, wherein the arrays of at least a part of said plurality of arrays of chiplets are all spaced apart.

5. The semiconductor structure (100) according to any one of claims 1 to 4, wherein the chiplets of at least one array are electrically independent of each other.

6. The semiconductor structure (100) according to claim 5, wherein the electrically independent chiplets are separated by an insulating region.

7. The semiconductor structure (100) according to any one of claims 1 to 6, wherein at least one chiplet of at least one array comprises a capacitor having capacitor electrodes, at least one capacitor electrode being electrically accessible on the second bonding face of said at least one chiplet.

8. The semiconductor structure (100) according to claim 7, wherein the electrodes of the capacitor extend inside pores of an insulating porous structure.

9. The semiconductor structure (100) according to any one of claims 1 to 8, wherein the number of chiplets in an array of chiplets is comprised between 1 and 1000, more particularly between 1 and 100, and still more particularly between 1 and 10.

10. The semiconductor structure (100) according to any one of claims 1 to 9, wherein the second bonding face of an array of chiplets has an area comprised between 1 mm² and 10 cm².

11. The semiconductor structure (100) according to any one of claims 1 to 10, wherein at least one array of chiplets is hybridly bonded to a die of the wafer or to an array of dies of the wafer.

12. The semiconductor structure (100) according to claim 11, wherein the part of the first bonding face bounded by said die or said array of dies comprises an electric contact pad.

13. A method of manufacturing a semiconductor structure (100) according to any one of claims 1 to 21.

14. The method according to claim 13, said method further comprising a step of dicing at least one portion of the semiconductor structure (100), said portion being formed of at least one array of chiplets and the part of the wafer hybridly bonded to said at least one array of chiplets.
